# FASCICULE DE BREVET EUROPEEN

(11) **EP 0 614 579 B1**
(45) Date de publication et mention de la délivrance du brevet: **27.03.1996**
(21) Numéro de dépôt: 93901772.9
(22) Date de dépôt: 25.11.1992
(51) Int. Cl.: H01S 3/25, H01S 3/085

(54) **ENSEMBLE DE LASERS A SEMICONDUCTEUR**
ANORDNUNG VON HALBLEITERLASERN.
SEMICONDUCTOR LASER ASSEMBLY

(30) Priorité: 26.11.1991 FR 9114563
(43) Date de publication de la demande: 14.09.1994
(73) Titulaire: COMMISSARIAT A L'ENERGIE ATOMIQUE, F-75752 Paris Cédex 15 (FR)
(72) Inventeur: PFISTER, Jean-Claude, F-38330 Montbonnot (FR)
(74) Mandataire: Signore, Robert
(86) Numéro de dépôt international: FR9201097
(87) Numéro de publication internationale: WO9311590

(56) Documents cités:
- APPLIED PHYSICS LETTERS. vol. 58, no. 8, 25 February 1991, NEW YORK US pages 804 - 806 M. ORENSTEIN ET AL. 'Two-dimensional phase-locked arrays of vertical- cavity semiconductor lasers by mirror reflectivity modulation'
- APPLIED PHYSICS LETTERS. vol. 56, no. 21, 21 Mai 1990, NEW YORK US pages 2089 - 2091 D.G. DEPPE ET AL. 'Phase-coupled two-dimensional AlxGa1-xAs-GaAs vertical- cavity surface-emitting laser array'
- ELECTRONICS LETTERS. vol. 26, no. 23, 8 November 1990, STEVENAGE GB pages 1944 -1946 H.-J-YOO ET AL. 'Phase-locked two-dimensional arrays of implant isolated vertical cavity surface emitting lasers'
- APPLIED PHYSICS LETTERS. vol. 58, no. 23, 10 Juin 1991, NEW YORK US pages 2616 - 2618 D.G. DEPPE ET AL. 'Bistability in an AlAs-GaAs-InGaAs vertical-cavity surface-emitting laser'

## Description

### Domaine technique

La présente invention a pour objet un ensemble de lasers à semiconducteur. Elle trouve une application dans de nombreux domaines : télécommunications optiques, pompage optique, traitement de matériaux, etc..

### Etat de la technique antérieure

L'augmentation de la puissance des lasers à semiconducteurs ne peut pas être obtenue par la simple augmentation de la surface active, car il apparaît des instabilités de modes et des filaments émetteurs mal contrôlés. On est donc amené à définir des émetteurs élémentaires formés par des zones actives de petites dimensions latérales. L'augmentation de puissance est alors réalisée par la multiplication de ces émetteurs élémentaires.

On gagne beaucoup en qualité de faisceau en assurant une cohérence de la phase optique entre les émetteurs par couplage entre eux. Le couplage le plus simple est obtenu par onde évanescente, (c'est-à-dire par recouvrement des parties évanescentes des modes de deux émetteurs élémentaires voisins). Ce type de couplage favorise l'oscillation de deux émetteurs voisins en opposition de phase, ce qui induit un diagramme de rayonnement multilobe. Dans le cas des laser multirubans, où l'onde lumineuse se propage parallèlement à la surface du semiconducteur, divers moyens ont été proposés pour assurer un couplage en phase, qui produit une émission en un seul lobe, perpendiculaire à la face de sortie (généralement obtenue par clivage).

Cette technique est décrite par exemple dans l'article de J. KATZ et al intitulé "Diffraction coupled phase locked semiconductor laser array" publié dans Appl. Phys. Lett. 42, (7) 1 April 1983 pp. 554-556 et dans l'article de L.J. MAWST et al. intitulé "CW high-power diffraction-limited-beam operation from resonant optical waveguide arrays of diode lasers" publié dans Appl. Phys. Lett. 58 (1), 7 January 1991, pp. 22-24.

Le développement récent de lasers à cavité verticale émettant par la surface permet d'envisager des matrices de points émetteurs au lieu d'une ligne émettrice, ainsi qu'une émission perpendiculaire à la surface de la puce de semiconducteur et non sur la tranche, ceci sans complications technologiques.

De telles matrices sont décrites notamment dans l'article de M. ORENSTEIN et al intitulé "Two-dimensional phase-locked arrays of vertical-cavity semiconductor lasers by mirror reflectivity modulation" publié dans Appl. Phys. Lett 58 (8) 25 February 1991, pp. 804-806.

En général, une matrice de lasers de ce type comprend un substrat conducteur et, sur ce substrat, un miroir inférieur, une couche active (éventuellement encadrée par des couches de confinement), et un miroir supérieur formé d'une matrice de zones réfléchissantes (par exemple une matrice de 4 x 4 zones). Le couplage entre les différents éléments verticaux est obtenu par diffraction au niveau des bords des zones réfléchissantes. L'ensemble de cette structure se comporte comme une pluralité de lasers (16 dans le cas d'une matrice de 4 x 4) légèrement couplés entre eux.

Si de telles structures sont intéressantes à certains égards, elles présentent encore l'inconvénient de conduire à un faisceau multilobe, donc peu directif. Cet inconvénient vient encore de ce que le couplage produit entraîne une opposition de phase entre les lasers élémentaires voisins, ce qui conduit à un diagramme de rayonnement de type anti-symétrique.

### Exposé de l'invention

L'invention a justement pour but de remédier à cet inconvénient. A cette fin, elle propose une structure qui est encore un ensemble de cavités verticales mais dont le faisceau d'émission n'est plus multilobe mais monolobe. Ce résultat est obtenu essentiellement par une nouvelle structure du miroir supérieur. Selon l'invention ce miroir comprend une pluralité de zones à grande réflectivité entourées de zones à réflectivité plus faible et comprend en outre des zones métallisées servant d'amenées de courant, ces zones métallisées étant situées au-dessus des zones à réflectivité plus faible. Les zones à grande réflectivité peuvent être organisées sous forme de matrice.

Ainsi, dans la structure de l'invention, la densité de courant injecté n'est pas homogène et présente une répartition telle que les maximas de densité de courant correspondent aux minimas de réflectivité du miroir supérieur. Le Demandeur a observé que, dans ces conditions, le couplage optique provoquait une mise en phase des différents éléments lasers ce qui, globalement, conduit à un diagramme de rayonnement monolobe. Les zones de plus faible réflectivité servent à séparer les résonateurs monomodes élémentaires.

Les avantages principaux procurés par l'invention sont donc doubles :
- par rapport aux lasers multirubans couplés en phase, la possibilité d'avoir une surface émissive au lieu d'une ligne et, par conséquent, une divergence angulaire réduite dans les deux directions sans introduire d'optique cylindrique, ainsi qu'une densité de puissance limitée sur la face de sortie permettant une meilleure fiabilité ;
- par rapport aux matrices de lasers à cavité verticale existantes, le couplage en phase qui produit un faisceau lumineux de bonne qualité géométrique utilisable directement ou par l'intermédiaire d'une optique simple.

### Brève description des dessins

- la figure 1 illustre, en coupe, une variante de réalisation d'un ensemble selon l'invention,
- la figure 2 montre la structure en vue de dessus.

### Exposé détaillé d'un mode de réalisation

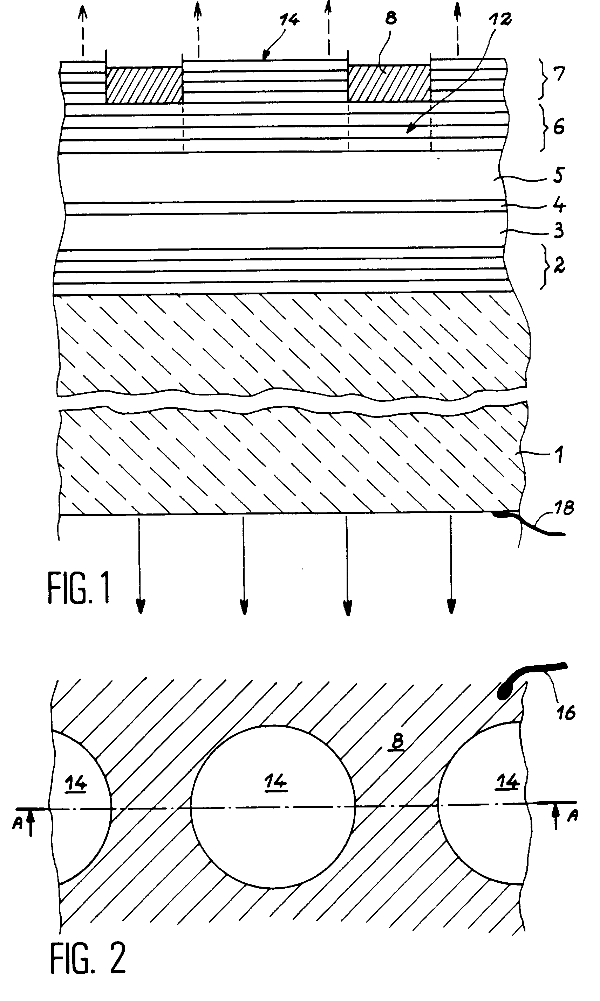

La structure illustrée sur la figure 1 est une coupe par un plan passant par le diamètre des miroirs à forte réflectivité (ligne AA sur la figure 2). Cette structure comprend :
- un substrat monocristallin conducteur 1 (par exemple en GaAs de type n⁺) qui peut être transparent à la longueur d'onde émise, ce substrat est muni d'une connexion électrique 18, qui sert d'amenée de courant,
- un miroir inférieur 2, par exemple constitué d'un empilement de couches alternativement de fort et de faible indices, d'épaisseur λ/4 où λ est la longueur d'onde utilisée, fortement dopées du même type que le substrat (exemple : 15 à 25 périodes de GaₓAlₗ₋ₓAs/Ga_{y}Al_{l-y}As de type n dopé à 3 à 10 x 10¹⁸cm⁻³),
- une couche de confinement 3 à indice graduel,
- une couche active 4, par exemple constituée d'un ou plusieurs puits quantiques de composition et d'épaisseur adaptées à la longueur d'onde souhaitée (par exemple en Ga_{0,8}In_{0,2}As de 8 nm entre des barrières en GaAs), de dopage faible ou nul,
- une couche de confinement 5 sensiblement symétrique de la couche 3,
- une partie commune 6 de miroir supérieur, de structure analogue à la structure 2, avec un nombre de couches plus faible et un dopage de type opposé (par exemple 8 à 12 périodes de GaₓAlₗ₋ₓAs/Ga_{y}Al_{l-y}As de type p dopé à 3 à 10 x 10¹⁸cm⁻³),
- une partie complémentaire 7 du miroir supérieur (par exemple 5 à 10 périodes de structure équivalente au miroir 6 ou 2 à 5 périodes de Si/SiO₂ déposées avec une épaisseur de λ/4 par pulvérisation),
- des métallisations 8.

Sous les métallisations 8, on trouve donc des zones 12 à plus faible réflectivité et, en dehors, de ces métallisations des zones 14 à réflectivité plus forte.

Pour réaliser une telle structure ou toute structure équivalente on peut s'y prendre de deux manières différentes, l'une de type tout épitaxié, l'autre mixte :

### a) Voie "tout épitaxié"

Dans la voie "tout épitaxié", on réalise, dans une première phase, l'épitaxie d'un système multicouches complet, comprenant le miroir inférieur, la ou les couches actives, et le miroir supérieur (partie commune et partie complémentaire). Cet ensemble d'opérations est réalisé, selon des techniques de l'art antérieur, par une méthode d'épitaxie telle que l'épitaxie par jets moléculaires ou par dépôt chimique en phase vapeur. La plaquette issue du bâti d'épitaxie est ensuite traitée par des moyens classiques de photolithogravure (dépôt de résine, insolation pour masquage, attaque chimique ou plasma pour creuser les tranchées nécessaires dans la partie supérieure du miroir (miroir complémentaire). Un dépôt métallique suivi d'une deuxième étape de masquage achève la définition des électrodes.

### b) Voie mixte

Dans la voie "mixte", l'empilement de couches épitaxiées est réalisé de la même façon jusqu'à la partie commune du miroir supérieur. La plaquette est alors extraite du bâti d'épitaxie pour subir une métallisation, puis on effectue la photolithogravure des amenées de courant. On procède ensuite au dépôt du miroir complémentaire. Ce dépôt peut être réalisé sans inconvénient par des moyens conventionnels tels que pulvérisation cathodique ou évaporation sous vide et porter sur des matériaux différents des alliages utilisés dans la partie active, tels que silicium et silice, qui permettent des sauts d'indice optique plus fort et donc un plus petit nombre de couches. Une étape supplémentaire de masquage et de lithogravure donnera accès électriquement aux métallisations, mais il n'est pas nécessaire d'ouvrir cet accès à l'ensemble des électrodes et cette étape est donc peu critique.

Les miroirs 2, 6 et 7 peuvent être calculés pour que l'émission de lumière se fasse soit à travers les miroirs 6 et 7, soit à travers le substrat et ces deux miroirs, soit à travers le substrat seul qui dans ces deux derniers cas doit être transparent à la longueur d'onde émise.

Sur la figure 2, on voit, en vue de dessus, les zones 14 à forte réflectivité et, autour de ces zones, la couche 8 de métallisation qui, dans la variante illustrée, est d'un seul tenant.

Cette figure montre également une connexion 16 qui sert d'amenée de courant.

Naturellement, on pourrait réaliser des zones à forte réflectivité 14 qui ne seraient pas circulaires, mais carrées ou rectangulaires.

Il va de soi qu'on ne sortirait pas du cadre de la présente invention en remplaçant l'empilement de couches λ/4 dans les miroirs par un empilement réflecteur plus complexe destiné, par exemple, à améliorer la conduction du courant. De même, tout en conservant la même structure, on peut aménager un accès électrique indépendant à au moins certaines des amenées de courant, ce qui permet de contrôler électriquement les couplages correspondants et donc l'indicatrice d'émission de la matrice de lasers.

On peut encore réaliser un dispositif où la pluralité de miroirs à forte réflectivité n'est pas organisée rigoureusement en matrice, mais selon un motif différent approprié aux applications envisagées (circulaire par exemple).

## Revendications

1. Ensemble de lasers à semiconducteur à cavités verticales et à émission de surface comprenant un substrat conducteur (1), et sur ce substrat, successivement :
- un miroir inférieur (2),
- une couche optiquement active (4),
- un miroir supérieur (6, 7, 12, 14),
cet ensemble étant caractérisé par le fait que le miroir supérieur comprend une pluralité de zones à grande réflectivité (14) entourées de zones à réflectivité plus faible (12) et comprend en outre des zones métallisées (8) servant d'amenées de courant, ces zones métallisées (8) étant situées au-dessus des zones à réflectivité plus faible (12).

2. Ensemble de lasers selon la revendication 1, caractérisé par le fait que le miroir supérieur (6, 7) comprend un empilement de couches d'indice alternativement fort et faible avec un nombre de couches plus faible dans les zones à réflectivité plus faible (12) que dans les zones à grande réflectivité (14).

3. Ensemble de lasers selon la revendication 1, caractérisé par le fait que le miroir supérieur comprend un empilement de couches d'indice alternativement fort et faible (6) et, dans les zones à grande réflectivité (14), un moyen réfléchissant supplémentaire (7) pour augmenter cette réflectivité.

4. Ensemble de lasers selon la revendication 1, caractérisé par le fait que le miroir supérieur comprend un empilement de couches d'indice alternativement fort et faible (6, 7), cet empilement présentant des zones gravées (8) définissant les zones à réflectivité plus faible.

5. Ensemble de lasers selon la revendication 1, caractérisé par le fait que la couche active (4) est encadrée par deux couches de confinement (3, 5).

6. Ensemble de lasers selon la revendication 1, caractérisé par le fait que la couche active (4) est du type à multipuits quantiques.

7. Ensemble de lasers selon la revendication 1, caractérisé par le fait que le substrat (1) est transparent.

## Patentansprüche

1. Anordnung von Halbleiterlasern mit vertikalen Resonatoren und mit Oberflächenemission, umfassend ein leitendes Substrat (1) und auf diesem Substrat, sukzessive:
- einen unteren Spiegel (2),
- eine optisch aktive Schicht (4),
- einen oberen Spiegel (6, 7, 12, 14),
wobei diese Anordnung **dadurch gekennzeichnet** ist, daß der obere Spiegel eine Vielzahl Zonen großer Reflektivität (14) umfaßt, umgeben von Zonen schwächerer Reflektivität (12), und außerdem metallisierte Zonen (8) umfaßt, der Stromzuführung dienend, wobei diese metallisierten Zonen (8) sich über den Zonen schwächerer Reflektivität (12) befinden.

2. Anordnung von Lasern nach Anspruch 1, dadurch gekennzeichnet, daß der obere Spiegel (6, 7) einen Stapel aus Schichten mit abwechselnd hohem und niedrigem Index umfaßt, mit einer kleineren Anzahl Schichten in den Zonen schwächerer Reflektivität (12) als in den Zonen großer Reflektivität (14).

3. Anordnung von Lasern nach Anspruch 1, dadurch gekennzeichnet, daß der obere Spiegel einen Stapel aus Schichten (6) mit abwechselnd hohem und niedrigem Index umfaßt und, in den Zonen großer Reflektivität (14), eine zusätzliche reflektierende Einrichtung (7), um diese Reflektivität zu erhöhen.

4. Anordnung von Lasern nach Anspruch 1, dadurch gekennzeichnet, daß der obere Spiegel einen Stapel aus Schichten mit abwechselnd hohem und niedrigem Index umfaßt (6, 7), wobei dieser Stapel geätzte Zonen (8) aufweist, die die Zonen schwächerer Reflektivität definieren.

5. Anordnung von Lasern nach Anspruch 1, dadurch gekennzeichnet, daß die aktive Schicht (4) eingefügt ist zwischen zwei Einschließungs- bzw. Barrierenschichten (3, 5).

6. Anordnung von Lasern nach Anspruch 1, dadurch gekennzeichnet, daß die aktive Schicht (4) vom Typ Mehrfachpotentialtopfstruktur ist.

7. Anordnung von Lasern nach Anspruch 1, dadurch gekennzeichnet, daß das Substrat (1) transparent ist.

## Claims

1. Semiconductor laser array with vertical cavities and surface emission comprising a conductor substrate (1) and, on said substrate, in succession a lower mirror (2), an optically active layer (4) and an upper mirror (6,7,12,14), characterized in that the upper mirror comprises a plurality of high reflectivity areas (14) surrounded by lower reflectivity areas (12) and also comprises metallized areas (8) serving as current leads, said metallized areas (8) being positioned above the lower reflectivity areas (12).

2. Laser array according to claim 1, characterized in that the upper mirror (6, 7) comprises a stack of alternately high and low index layers with a smaller number of layers in the lower reflectivity areas (12) than in the high reflectivity areas (14).

3. Laser array according to claim 1, characterized in that the upper mirror comprises a stack of alternately strong and weak index layers (6) and, in the high reflectivity areas (14), a supplementary reflecting means (7) for increasing said reflectivity.

4. Laser array according to claim 1, characterized in that the upper mirror comprises a stack of alternately high and low index layers (6, 7), said stack having etched areas (8) defining the lower reflectivity areas.

5. Laser array according to claim 1, characterized in that the active layer (4) is surrounded by two confinement layers (3,5).

6. Laser array according to claim 1, characterized in that the active layer (4) is of the multiple quantum well type.

7. Laser array according to claim 1, characterized in that the substrate (1) is transparent.
